# EUROPEAN PATENT APPLICATION

(11) **EP 2 361 881 A1**
(43) Date of publication of application: **31.08.2011**
(21) Application number: 09827311.3
(22) Date of filing: 06.11.2009
(51) Int. Cl.: C01B 31/02, C10M 103/02, C23C 14/06, C23C 16/27, F16C 33/04

(54) **SLIDING MEMBER AND PROCESS FOR PRODUCING SAME**

(30) Priority: 19.11.2008 JP 2008295399
(71) Applicant: Honda Motor Co., Ltd., Minato-ku Tokyo 107-8556 (JP)
(72) Inventor: KOBAYASHI, Koji, Tochigi 321-3395 (JP)
(74) Representative: Beder, Jens
(86) International application number: PCT/JP2009/005896
(87) International publication number: WO 2010/058530

(57) **Abstract**

High surface pressure is applied to the sliding surfaces of the members 1 and 2, so that local solid contact occurs on sliding interfaces, and microscopic wear occurs on the sliding surfaces. The carbon-based molecules 12, which have rollable hollow structures, are included as separate molecules or aggregates of molecules in the lubricating film 11 of the sliding member 1. The carbon-based molecules 12 are exposed from the lubricating film 11 by the above microscopic wear, and a portion of the carbon-based molecules 12 is separated from the lubricating film 11, and is supplied to the sliding surfaces. Since the carbon-based molecules 12 have rollable hollow structures, the separated carbon-based molecules 12 function as ball bearings on the molecular level on the sliding interfaces. In this case, when at least one separated carbon-based molecule 12 exist between the sliding interfaces, local friction can be reduced in comparison with a case in which separated carbon-based molecule 12 does not exist. As a result, friction can be greatly reduced on the sliding surfaces, mass production can be realized, and production cost can be reduced.

## Description

### Technical Field

The present invention relates to a sliding member having a sliding surface which slides on a counter member, and relates to a production method therefor. In particular, the present invention relates to an improvement in the sliding surface for reduction of friction against the counter member.

### Background Art

In the field of sliding members, under conditions in which lubricant oil is provided between a sliding member and a counter member in an engine for automobiles or the like, reduction of friction against the counter member is improved, and wear resistance is improved. In order to realize these, ball bearings are often used.

However, for example, when ball bearings are used for many sliding portions in an engine, weight reduction may be difficult, and the setting space may be small. Due to this, instead of using ball bearings, lubricating films made of PTFE (Teflon which is registered trademark) or molybdenum disulfide are coated on sliding surfaces. In this manner, solid lubrication characteristics may be improved. However, the effects by the lubricating films may be less than those by the ball bearings.

From the above background, in order to reduce friction on a sliding surface greatly, various techniques have been proposed. For example, Japanese Unexamined Patent Application Publication No. 2003-62799 has proposed a technique in which fullerene or carbon nanotubes are vapor deposited on sliding surfaces of two graphite substrates, and molecules thereof, which are disposed between the graphite substrates, function as molecular bearings in order to use this technique for nanoscale structures.

In this technique, high effects of friction prevention may be obtained. However, fullerene or carbon nanotube should be precisely positioned on sliding surfaces of two graphite substrates by a vaporization method. Due to this, it is difficult to produce sliding surfaces having molecular bearings, and mass production therefor may be very difficult. In addition, production cost may not be reasonable for automobile parts.

### DISCLOSURE OF THE INVENTION

An object of the present invention is to provide a sliding member which enables great reduction of friction, mass production therefor, and reduction of production cost. Another object of the present invention is to provide a production method therefor.

According to one aspect of the present invention, a sliding member comprising: a sliding surface sliding on a counter member; and a lubricating film formed on the sliding surface, wherein carbon-based molecules having rollable hollow structures are included in the lubricating film as separate molecules or aggregates of molecules.

In the sliding member of the aspect of the present invention, when high surface pressure is applied to sliding surfaces of members, local solid contact occurs on the sliding interfaces, and microscopic wear occurs on the sliding surfaces of the members. The carbon-based molecules, which have rollable hollow structures, are included as separate molecules or aggregates of molecules in the lubricating film of the sliding member. Thus, the carbon-based molecules are exposed from the lubricating film by the above microscopic wear, and a portion of the carbon-based molecules is separated from the lubricating film, and is supplied to the sliding interfaces. Since the carbon-based molecules have rollable hollow structures, the separated carbon-based molecules function as ball bearings on the molecular level on the sliding interfaces.

In this case, when at least one separated carbon-based molecule exist between the sliding surrfaces, local friction can be reduced in comparison with a case in which separated carbon-based molecule does not exist, so that friction can be greatly reduced on the sliding interfaces. Since energy loss by friction can be reduced, fuel consumption of internal-combustion engines (engines of automobiles or the like) using the sliding member can be improved. Since the above effects can be obtained by a simple structure in which the carbon-based molecules, which have rollable hollow structures, are included in the lubricating film of the sliding member, mass production can be realized and production cost can be reduced.

The sliding member of the present invention can have various structures. According to a preferred embodiment, the lubricating film may be a diamond-like carbon film (DLC film). In this embodiment, DLC itself may have a low friction, a high hardness (good wear resistance), chemical stability (good corrosion resistance), and a weak adhesion (good seizure resistance), so that sliding characteristics of the lubricating film can be good. Since DLC includes carbon and hydrogen, which are harmless, as a main component, harmony with the environment can be satisfied, and abundance of raw material (hydrocarbon gas or graphite) is much and stable.

According to a preferred embodiment of the present invention, the carbon-based molecule may be at least one selected from the group consisting of fullerenes, carbon nanotubes, adamantine, hydrogen compounds of fullerenes, hydrogen compounds of carbon nanotubes, and hydrogen compounds of adamantine. The fullerene C₆₀ can be used as fullerene.

For example, when the sliding member of the present invention is used for engines, a cylinder bore or a piston can be used as the sliding member. For example, when a cylinder bore is used as the sliding member, the counter member may be a piston. When a piston is used as the sliding member, the counter member may be a cylinder bore. The lubricating film of the present invention may be used for not only the sliding member but also the counter member.

According to another aspect of the present invention, a production method for a sliding member includes: lubricating film formation in which by performing plasma processing on a raw material of a lubricating film, the lubricating film is formed on a sliding surface sliding on a counter member, wherein in the lubricating film formation, a carbon-based molecular gas, which includes at least one of carbon-based molecules having rollable hollow structures and hydrogenated carbon-based molecules, is supplied to plasma of the raw material, the carbon-based molecular gas is ionized, and the ionized carbon-based molecular gas is received in the lubricating film and is molecularized.

The production method for a sliding member of the aspect of the present invention can obtain the same effects as the sliding member of the present invention.

According to the sliding member of the present invention or the production method therefor, the carbon-based molecules have rollable hollow structures are supplied to the sliding interfaces by the above microscopic wear, the carbon-based molecules function as ball bearings on the molecular level.

As a result, friction can be greatly reduced on the sliding surfaces, mass production can be realized, production cost can be reduced, and another effect can be obtained.

### BRIEF DESCRIPTION OF DRAWINGS

Fig. 1 is a side cross sectional diagram which schematically shows a structure of a sliding member of one embodiment according to the present invention.
Figs. 2A and 2B show a condition of a portion proximate to a sliding interface of a sliding member (shown in Fig. 1) which slides on a counter member. Fig. 2A is a side cross sectional diagram which shows a fluid lubricating condition in which lubricating oil is provided between sliding interfaces, and Fig. 2B is a side cross sectional diagram which shows a boundary lubricating condition in which local solid contact occurs on sliding interfaces.
Fig. 3 is a partial enlarged diagram of a portion (denoted by point P) at which the local solid contact shown in Fig. 2B occurs.
Fig. 4 is a diagram which shows a portion of schematic structure of an internal-combustion engine to which a cylinder bore is provided as a specific use example of the sliding member shown in Fig. 1.
Fig. 5 is a partial enlarged diagram of a portion (denoted by point Q) at which the local solid contact shown in Fig. 4 occurs.
Figs. 6A and 6B are diagrams which show an existing feature of carbon-based molecule in a lubricating film.

### EXPLANATION OF REFERENCE NUMERALS

Reference numeral 1 denotes a sliding member, 2 denotes a counter member, 12 and 112 denote a carbon-based molecule, 101 denotes a cylinder bore (sliding member), 102 denotes a piston (counter member), and 132 denotes a ring portion (counter member).

### BEST MODE FOR CARRYING OUT THE INVENTION

### 1. Structure of Sliding Member

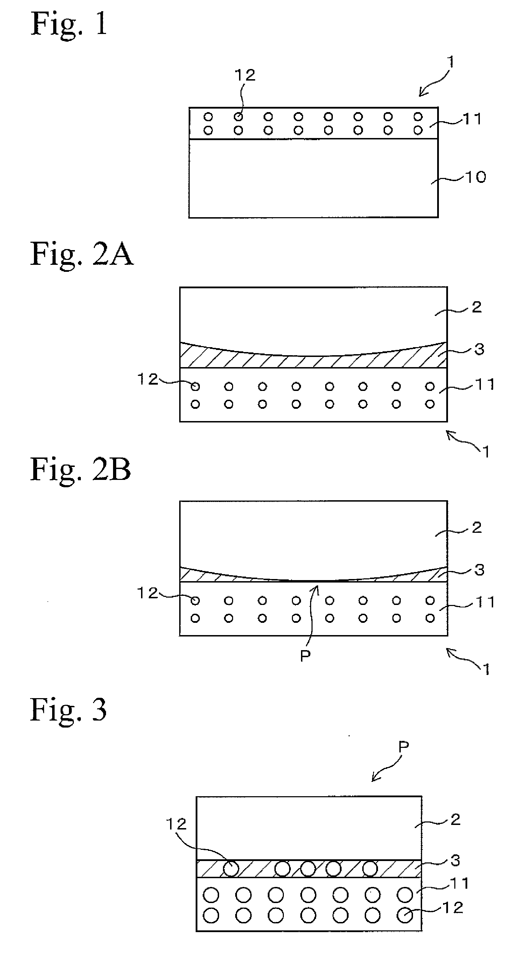

An embodiment of the present invention will be described with reference to the Figures hereinafter. Fig. 1 is a side cross sectional diagram which schematically shows a structure of a sliding member 1 of one embodiment according to the present invention. The sliding member 1 has a main body portion 10, and a lubricating film 11 is formed on a surface of the main body portion 10. Carbon-based molecules 12 having rollable hollow structures are dispersed and included in the lubricating film 11.

For example, the lubricating film 11 is a diamond-like carbon film (DLC film) made of diamond-like carbon (DLC). For example, the lubricating film 11 has a film thickness of 3 µm. The lubricating film 11 is not limited to the DLC film, and the lubricating film 11 can use various modifications. For example, a dry coating film made of CrN, TiCN, TiAlN, or the like may be used. Alternatively, a plating film made of Ni or the like may be used.

DLC itself has a low friction, a high hardness (good wear resistance), chemical stability (good corrosion resistance), and a weak adhesion (good seizure resistance). Since DLC includes carbon and hydrogen, which are harmless, as a main component, harmony with the environment can be satisfied, and abundance of raw material (hydrocarbon gas or graphite) is much and stable. Specifically, in comparison with the above other material, DLC has a friction lower than that of CrN having the same corrosion resistance. DLC is superior to Ni plating in any characteristics.

Thus, DLC has various merits as a lubricating film in comparison with the above other material, so that DLC is desirable for the lubricating film. In a case in which fullerene is used for the carbon-based molecules 12, when a surface of the DLC film is graphitized by energy in sliding, the DLC film functions as a nanoscale gear (nanogear) at a point which contacts fullerene, and the DLC film contributes to reduction of friction.

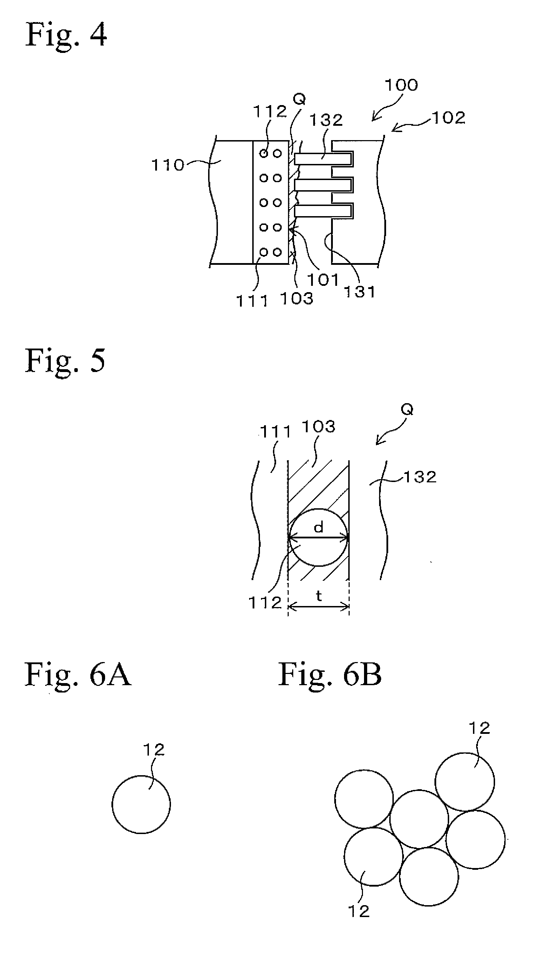

When local solid contact occurs between a portion of the carbon-based molecules 12 and a counter member (not shown in the Figure) facing the lubricating film 11, the portion thereof is separated from the lubricating film 11 at a sliding surface, and functions as a molecular bearing. As shown in Fig. 6A, the carbon-based molecules 12 exist as separate molecules, or as shown in Fig. 6B, the carbon-based molecules 12 exist as aggregates of molecules. In Figs. 6A and 6B, the drawings of the carbon-based molecules 12 are simplified for the sake of convenience.

Spherical molecules (for example, fullerene C₆₀) or hydrogen compounds thereof are the most desirably used as the carbon-based molecules 12 included in the lubricating film 11. In this case, the spherical molecules are allotropes of carbon which are obtained by synthesizing many carbon atoms and of which a rolling direction with respect to an external load is not anisotropic. Alternatively, pseudospherical bodies having closed structures may be used as the carbon-based molecules 12. For example, the pseudospherical body may be higher order fullerenes (for example, C₇₀, C₇₄, C₇₆, or the like), adamantine (C₁₀H₁₆), or hydrogen compounds thereof. Alternatively, molecules (for example, carbon nanotubes) having a circular cross section in least one direction or a hydrogen compound may be used as the carbon-based molecules 12.

Specifically, fullerene C₆₀ has a spherical shape having a diameter of about 0.7 nm and has a high hardness, so that the spherical shape can be maintained under a high load. Since the above separation of the carbon-based molecules 12 is a small portion of the surface of the lubricating film 11, deposition of the carbon-based molecules 12 is prevented in the lubricating oil between the lubricating film 11 and the counter member. When the lubricating oil passes through a filter in an apparatus, clogging of the filter by the carbon-based molecules 12 is prevented.

As describe above, from a viewpoint of rolling ease, the carbon-based molecule 12 desirably has a spherical shape in the same manner as fullerene C₆₀. When higher order fullerene (for example, C₇₀ or the like), carbon nanotube, adamantine (C₁₀H₁₆), or the like is used, the materials may roll (be rollable), and may have a very small diameter (few nanometers or less) in the rolling direction. In a case in which the above materials are used, when the diameter of the rolling direction exceeds the above value, it may be difficult for the carbon-based molecule 12 to roll. In a case in which adamantine is used, adamantine is smaller than fullerene, and the carbon-based molecule 12 can thereby enter a clearance between the sliding interfaces which fullerene cannot easily enter, so that sliding characteristics are good.

In a case in which the carbon-based molecule 12 does not have a spherical shape (for example, the carbon-based molecule 12 has a columnar shape in the same manner as the carbon-based molecules 12), it is desirable that carbon nanotubes easily roll in a sliding direction when carbon nanotubes are separated from the surface (sliding surface) of the lubricating film 11. In order to realize this, carbon nanotubes are desirably oriented beforehand in forming the lubricating film 11.

When the carbon-based molecule 12 has the above structure, it is important that the carbon-based molecule 12 be rollable and have a nanoscale size in order to realize molecular bearing function.

### 2. Production Method for Sliding Member

A production method of the sliding member 1 of the one embodiment according to the present invention will be explained. In the production method of the sliding member 1, by performing plasma processing on a raw material of the lubricating film 11, the lubricating film 11 is formed on the surface (sliding surface) of the main body portion 10 (lubricating film formation).

In this lubricating film formation, a carbon-based molecular gas, which includes at least one of carbon-based molecules and hydrogenated carbon-based molecules, is supplied to a plasma of the raw material, so that the carbon-based molecular gas is dehydrogenated and ionized. The plasma of the raw material collides with the surface of the main body portion 10, so that the raw material is deposited on the surface thereof, and the lubricating film 11 is formed thereon. In this case, the ionized carbon-based molecular gas also collides with the surface of the main body portion 10. Thus, the ionized carbon-based molecular gas is received by the lubricating film 11, and receives carbon, thereby being molecularized in the lubricating film.

In this case, in high speed collision with the main body portion 10 to which voltage is applied, the ionized carbon-based molecular gas loses energy rapidly by the collision. In this case, in order that the ionized carbon-based molecular gas and hydrogen ion stabilize, the ionized carbon-based molecular gas receives the hydrogen ion. As a result, the ionized carbon-based molecules may exist as hydrogenated fullerene in the carbon-based molecules.

In the above manner, the lubricating film 11 is formed on the surface of the main body portion 10 of the sliding member 1, and the carbon-based molecules 12 are dispersed in the lubricating film 11. As described below, a CVD (Chemical Vapor Deposition) method and a PVD (Physical Vapor Deposition) method are used as the concrete method of the lubricating film formation using the plasma processing.

A case of using a CVD method will be explained. First, the main body portion 10 of the sliding member 1 is provided in a vacuum furnace of a CVD apparatus. Next, for example, vacuum degree of the vacuum furnace is adjusted to be about 10⁻² to 10⁻³ Pa, and temperature thereof is adjusted to be about 50 to 150 degrees C. Then, DC pulse voltage is applied to the main body portion 10.

Next, reducing gas (for example, argon gas) is supplied in the vacuum furnace and is brought into a plasma state, so that cleanness of the surface of the main body portion 10 is improved by ion bombardment effect. Next, a material gas (hydrocarbon gas (for example, butane, acetylene, or the like) in a case of DLC film formation) of the lubricating film 11 and a carbon molecule ball (for example, fullerene) of which a portion is hydrogenated are supplied into the vacuum furnace.

In this case, gas flow amount, pressure, temperature, bias voltage value, and pulse duty value (ratio of one cycle of square wave to width of high pulse side) are always adjusted to be within a range enabling an optimal plasma state to be maintained. Thus, the lubricating film 11 is formed on the surface of the main body portion 10, and the carbon-based molecules 12 are dispersed in the lubricating film 11.

A case of using a PVD method will be explained. First, the main body portion 10 of the sliding member 1 is provided in a vacuum furnace of a PVD apparatus. Next, for example, a vacuum degree of the vacuum furnace is adjusted to be about 10⁻² to 10⁻³ Pa, temperature thereof is adjusted to be about 50 to 150 degrees C. Then, DC pulse voltage is applied to the main body portion 10.

Next, reducing gas (for example, argon gas) is supplied in the vacuum furnace and is brought into a plasma state, so that cleanness of the surface of the main body portion 10 is improved by ion bombardment effect. Next, a solid material (for example, graphite) of the lubricating film 11, which is disposed in a vacuum furnace, is brought into a plasma state by an arc discharge method, an electron beam irradiation method, or the like, and a carbon-based molecule (for example, fullerene) of which a portion is hydrogenated is also supplied into the vacuum furnace and is brought into a plasma state. Thus, the lubricating film 11 is formed on the surface of the main body portion 10, and the carbon-based molecules 12 are dispersed in the lubricating film 11.

### 3. Action of Sliding Member

An action of the sliding member 1 will be explained with reference to Figs. 2 and 3. Figs. 2A and 2B show a condition of a portion proximate to a sliding interface of a sliding member 1 and slides on a counter member 2. Fig. 2A is a side cross sectional diagram which shows a fluid lubricating condition in which lubricating oil 3 is provided between sliding interfaces, and Fig. 2B is a side cross sectional diagram which shows a boundary lubricating condition in which local solid contact occurs on sliding interfaces. Fig. 3 is a partial enlarged diagram of a portion (denoted by point P) at which the local solid contact shown in Fig. 2B occurs.

In a fluid lubricating condition shown in Fig. 2A, the lubricating oil is provided between the members 1 and 2, carbon-based molecules 12, which are included in the lubricating film 11, do not contribute to sliding of the sliding member 1. On the other hand, when high surface pressure is applied to the sliding surfaces of the members 1 and 2 and the sliding surfaces are in a boundary lubricating condition as shown in Fig. 2B, local solid contact occurs on sliding interfaces, and microscopic wear occurs on the sliding interfaces of the members.

The carbon-based molecules 12, which have rollable hollow structures, are included as separate molecules or aggregates of molecules in the lubricating film 11 of the sliding member 1. Thus, the carbon-based molecules 12 are exposed from the lubricating film 11 by the above microscopic wear, and a portion of the carbon-based molecules 12 is separated from the lubricating film 11, and is supplied to the sliding interfaces. Since the carbon-based molecules 12 have rollable hollow structures, as shown in Fig. 3, the separated carbon-based molecules 12 function as ball bearings on the molecular level on the sliding interfaces. In this case, when at least one separated carbon-based molecule 12 exist between the sliding interfaces, local friction can be reduced in comparison with a case in which separated carbon-based molecule 12 does not exist. In particular, in this case, separated carbon-based molecule 12 can move in the lubricating oil and can thereby enter necessary portions, so that the friction reduction effects can be obtained.

As describe above, in the embodiment, since friction can be greatly reduced on the sliding interfaces, energy loss by friction can be reduced, and fuel consumption of internal-combustion engines (engines of automobiles or the like) using the sliding member 1 can be improved. Since the above effects can be obtained by a simple structure in which the carbon-based molecules 12, which have rollable hollow structures, are included in the lubricating film 11 of the sliding member 1, mass production can be realized and production cost can be reduced.

### 4. Use Example of Sliding Member

A specified use example of the sliding member will be explained with reference to Figs. 4 and 5. Fig. 4 is a diagram which shows a portion of schematic structure of an internal-combustion engine 100 (for example, engine) using a cylinder bore 101 as a specific use example of the sliding member 1. Fig. 5 is a partial enlarged diagram of a portion (denoted by point Q) at which the local solid contact occurs in the internal-combustion engine 100. In the internal-combustion engine 100, a piston 102 slides along an inner circumference surface (sliding surface) of an inside of the cylinder bore 101. The piston 102 has a skirt portion (not shown in the Figures), land portions 131, and ring portions 132. The skirt portion is formed at a lower portion of the piston 102, and land portions 131 are formed at an upper portion of the piston 102. The ring portions 132 are provided between the land portions 131.

The cylinder bore 101 corresponds to the sliding member 1, a portion of the cylinder block 110 corresponds to the main body portion 10, and the ring portions 132 correspond to the counter member. The lubricating film 111 is formed on the inner circumference surface of the cylinder bore 101. The carbon-based molecules 112, which have rollable hollow structures, are dispersed and included in the lubricating film 11 of the sliding member 1. The lubricating film 111 and the carbon-based molecule 112 correspond to the lubricating film 11 and the carbon-based molecule 12, and have the same structures as the lubricating film 11 and the carbon-based molecule 12.

In this internal-combustion engine 100, when the following feature is used, the above effects by the sliding member 1 can be effectively obtained. For example, as shown in Fig. 5, in a feature in which diameter d of the carbon-based molecule 112 (for example, in a case of spherical shape of material (for example, fullerene), diameter of the spherical shape, or in a case of columnar shape of material (for example, fullerene), diameter of circular bottom of the columnar shape) is set smaller than minimum oil film thickness t, this feature is desirable in a viewpoint of airtightness. Since the piston 102 rotates during sliding in a vertical direction with respect to the cylinder bore 101, in a feature of using carbon nanotubes, orientation of carbon nanotubes align in a sliding direction in accordance with the sliding.

## Claims

1. A sliding member comprising:
a sliding surface sliding on a counter member; and
a lubricating film formed on the sliding surface, wherein
carbon-based molecules having rollable hollow structures are included in the lubricating film as separate molecules or aggregates of molecules.

2. A sliding member according to claim 1, wherein
the lubricating film is a diamond-like carbon film.

3. A sliding member according to claim 1 or 2, wherein
the carbon-based molecule is at least one selected from the group consisting of fullerenes, carbon nanotubes, adamantine, hydrogen compounds of fullerenes, hydrogen compounds of carbon nanotubes, and hydrogen compounds of adamantine.

4. A sliding member according to one of claims 1 to 3, wherein
the fullerene is fullerene C₆₀.

5. A production method for a sliding member, comprising:
lubricating film formation in which by performing plasma processing on a raw material of a lubricating film, the lubricating film is formed on a sliding surface sliding on a counter member, wherein
in the lubricating film formation,
a carbon-based molecular gas, which includes at least one of carbon-based molecules having rollable hollow structures and hydrogenated carbon-based molecules, is supplied to plasma of the raw material,
the carbon-based molecular gas is ionized, and
the ionized carbon-based molecular gas is received in the lubricating film and is molecularized.

6. A production method for a sliding member according to claim 5, wherein the lubricating film is a diamond-like carbon film.

7. A production method for a sliding member according to claim 5 or 6, wherein
the carbon-based molecule is at least one selected from the group consisting of fullerenes, carbon nanotubes, adamantine, hydrogen compounds of fullerenes, hydrogen compounds of carbon nanotubes, and hydrogen compounds of adamantine.

8. A production method for a sliding member according to one of claims 5 to 7, wherein
the fullerene is fullerene C₆₀.

## Amended claims

### Amended claims under Art. 19.1 PCT

**1.** (Cancelled)

**2.** (Cancelled)

**3.** (Cancelled)

**4.** (Cancelled)

**5.** A production method for a sliding member, comprising:
lubricating film formation in which by performing plasma processing on a raw material of a lubricating film, the lubricating film is formed on a sliding surface sliding on a counter member, wherein
in the lubricating film formation,
a carbon-based molecular gas, which includes at least one of carbon-based molecules having rollable hollow structures and hydrogenated carbon-based molecules, is supplied to plasma of the raw material,
the carbon-based molecular gas is ionized, and
the ionized carbon-based molecular gas is received in the lubricating film and is molecularized.

**6.** A production method for a sliding member according to claim 5, wherein the lubricating film is a diamond-like carbon film.

**7.** A production method for a sliding member according to claim 5 or 6, wherein
the carbon-based molecule is at least one selected from the group consisting of fullerenes, carbon nanotubes, adamantine, hydrogen compounds of fullerenes, hydrogen compounds of carbon nanotubes, and hydrogen compounds of adamantine.

**8.** A production method for a sliding member according to one of claims 5 to 7, wherein
the fullerene is fullerene C₆₀.
